# EUROPÄISCHE PATENTSCHRIFT

(11) **EP 0 799 379 B1**
(45) Veröffentlichungstag und Bekanntmachung des Hinweises auf die Patenterteilung: **04.11.1998**
(21) Anmeldenummer: 95942187.6
(22) Anmeldetag: 20.12.1995
(51) Int. Cl.: F02P 7/03, H03K 3/543, H03K 17/54

(54) **ZÜNDANLAGE**
IGNITION SYSTEM
SYSTEME D'ALLUMAGE

(30) Priorität: 20.12.1994 DE 4445467
(43) Veröffentlichungstag der Anmeldung: 08.10.1997
(73) Patentinhaber: DAIMLER-BENZ AKTIENGESELLSCHAFT, 70546 Stuttgart (DE)
(72) Erfinder: MARSCHALL, Norbert, D-60439 Frankfurt (DE); CHMOLLA, Wilfried, D-63128 Dietzenbach (DE)
(74) Vertreter: Fröhling, Werner Otto, Dr.
(86) Internationale Anmeldenummer: EP9505055
(87) Internationale Veröffentlichungsnummer: WO9619663

(56) Entgegenhaltungen:
- EP-A- 0 463 800
- EP-A- 0 463 842
- US-A- 3 840 955
- US-A- 5 012 153

## Beschreibung

Die Erfindung betrifft eine Zündanlage nach dem Oberbegriff des Anspruchs 1.

An elektronische Bauelemente werden im Kraftfahrzeug, und vor allem im Motorraum, besondere Anforderungen gestellt. Einerseits müssen die Halbleiterbauelemente hohe Temperaturen vertragen und andererseits werden an die Bauelemente extrem hohe Forderungen gestellt, falls die für die Zündung erforderliche hohe Spannung direkt an die Halbleiterbauelemente angelegt wird. Um die hohen Spannungen aufzunehmen, müssen mehrere Halbleiterbauelemente in Reihe geschaltet werden. Das ist aufwendig und teuer. Eine Zerstörung von Bauelementen durch Überspannungen ist dennoch nicht mit Sicherheit auszuschließen.

Aus der DE-A-37 22 666 ist eine Zündverteileranordnung bekannt, bei der die von der Zündspule gelieferten Zündimpulse durch Halbleiterbauelemente an die Zündkerze angelegt werden. Die Halbleiterbauelemente werden dabei durch Bestrahlung mit Licht geschaltet.

Feldemitter sind u. a. aus Veröffentlichungen von C. Spindt, aus dem Standford Research Institut bekannt. Sie werden bisher überwiegend für Displays verwendet.

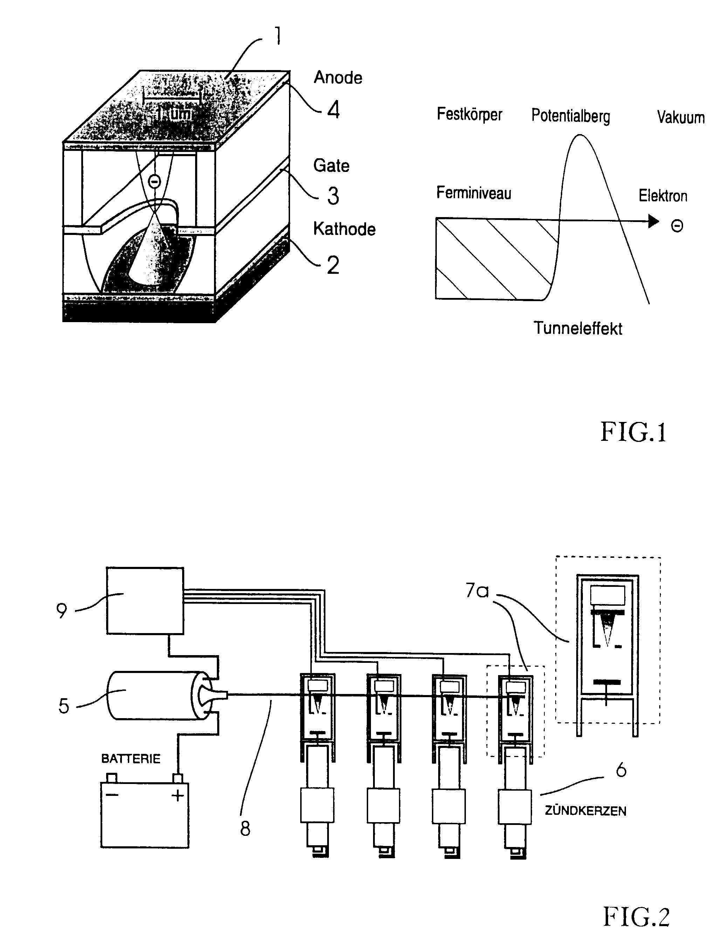

Der Feldemitter, ein Bauelement der Vakuummikroelektronik, nutzt die gesteuerte Emission von Elektronen aus einer Metallspitze oder -kante ins Vakuum. In der Fig. 1 sind der prinzipielle Aufbau eines vertikalen Feldemitters mit Feldemissionskathode und der Tunneleffekt dargestellt. Die Metallspitze befindet sich in einem hohen elektrischen Feld auf Raumtemperatur.

Durch die Form der Metallspitze sind Feldstärkeüberhöhungen bis in den Bereich einiger 10⁷ V/cm möglich. Diese Feldstärken reichen für Elektronen aus, um den Potentialberg in der Höhe der Austrittsarbeit zu durchtunneln. Wegen des geringen Abstands der Kathodenspitze zum Rand des Gate-Lochs und des wesentlich größeren Abstands zur Anode bei Spannungen in der gleichen Größenanordnung an beiden Elektroden, bestimmt im wesentlichen die Gate-Spannung die für die Feldemission an der Kathode herrschende Feldstärke.

Die Elektronen werden nach dem Austreten aus der Spitze bereits in Kathodennähe auf einen merklichen Teil der Endgeschwindigkeit beschleunigt im Unterschied zur Emission aus thermischen Kathoden. Ihre Flugrichtung wird im wesentlichen durch den Austrittswinkel bestimmt, solange die Anodenspannung größer als die Gate-Spannung ist. Ist die Anodenspannung kleiner als die Gate-Spannung, werden die Elektronen in Anodennähe abgebremst. Einige Elektronen (mit großem Winkel zur Rotationsachse der Spitze) kehren ihre Geschwindigkeitsrichtung um und fliegen zum Gate. Die übrigen Elektronen erreichen die Anode. Einige von ihnen werden von der Anode reflektiert und fliegen ebenfalls zum Gate. Da die Elektronengeschwindigkelten in Anodennähe sehr klein sind, können sich bei großen Strömen Raumladungen bilden, die das bremsende elektrische Feld erhöhen.

Genaue Untersuchungen der Raumladungen sind noch Gegenstand der Forschung. Es fließen ein Anoden- und ein Gatestrom. Das Stromverhältnis hängt neben dem Verhältnis der Spannungen an der Anode und am Gate auf komplexe Weise von der geometrischen Anordnung ab.

Der Erfindung liegt die Aufgabe zugrunde, Hochspannungssteuerelemente für eine Zündanlage anzugeben, welche in der Lage sind, die hohen Spannungen für die Zündkerze zu schalten und zu regeln.

Diese Aufgabe wird durch die im Kennzeichen des Anspruchs 1 angegebenen Merkmale gelöst. Weiterbildungen der Erfindung sind in den Unteransprüchen enthalten.

Die Vorteile der Erfindung liegen vor allem In einer spürbaren Erhöhung der Lebensdauer der Zündanlage, insbesondere der Zündkerzen, die praktisch wartungsfrei werden.

Ausführungsbeispiele der Erfindung werden nachstehend anhand der Zeichnung näher erläutert.

Dabei zeigt:
- Fig. 1: das Prinzip der Feldemission aus einer Einzel-Spitze (Stand der Technik);
- Fig. 2: das Prinzipschaltbild eines Zündsystems mit Feldemissionsschaltern bei herkömmlicher Zündspule (Ausführungsbeispiel 1);
- Fig. 3: das Prinzipschaltbild eines Zündsystems mit Feldemitter-Schaltern und Stromregelung bei Versorgung aus zwei Spannungsquellen (Ausführungsbeispiel 2) und
- Fig. 4: das Ersatzschaltbild des Sekundärkreises eines Zündsystems mit Zündspule.

Wegen seiner Eigenschaften, hohe Sperrspannungen und z. Z. erreichbare Ströme bis in den mA-Bereich zu steuern, eignen sich erfindungsgemäß Feldemitterarrays mit etwa 10⁴ bis 10⁵ Einzelemlttern als Steuerelemente in Zündanlagen für Verbrennungsmotoren. Diese 10⁴ bis 10⁵ Einzelfeldemitter sind auf einer Fläche von etwa 1 mm² in integrierter Technik ausgeführt.

### Beispiel 1:

Bei einer bevorzugten Ausführungsform der Erfindung wird der bekannte mechanische Zündverteiler durch elektronische Hochspannungsschalter (Feldemitter) ersetzt. Das übrige Zündsystem bleibt gegenüber dem bekannten System mit mechanischem Verteiler und Zündspule erhalten. Das Prinzip mit den neuartigen elektronischen Verteilerschaltern unter Einsatz von Feldemittern 7a ist in Fig. 2 dargestellt.

Die Spannung für den Zündvorgang und die Energie für den sich anschließenden Brennvorgang der Zündkerze wird von einer Spule 5 geliefert und auf einen Hochspannungsbus 8 gegeben, der die Hochspannungsschalter 7a verbindet.

Für einen Zündvorgang wird der zugeordnete elektronische Schalter über eine Steuerleitung vom Zündsteuergerät 9 eingeschaltet. Anschließend baut sich die Hochspannung bis zum Zündzeitpunkt auf und der Zündkerzenbrennstrom fließt über den mikroelektronischen Verteilerschalter 7. Nach dem Ende des Brennvorgangs und dem Abbau der Zündenergie wird der Verteilerschalter wieder abgeschaltet.

Die Betriebsbedingungen für einen beispielhaften mikroelektronischen Verteilerschalter in einer Zündanlage sind in der Tabelle 1 zusammengefaßt. Die zeit- un drehzahlabhängigen Größen sind Mittelwerte. Die Zündspannung zum Zünden des Brennvorgangs beträgt 15 bis 25 kV. Nach dem Zünden bricht durch den Stromfluß von etwa 40 mA die Hochspannung auf etwa 5000 V Brennspannung zusammen. Die Brenndauer beträgt etwa 0,5 bis 2 ms. Der Vorgang wiederholt sich bei 5000 U/min bei einem Vierzylindermotor für den Zündspannungsbus alle 6 ms und für jeden einzelnen mikroelektronischen Verteilerschalter alle 24 ms. Unter der Annahme, daß das Feldemitterarray bei 100 V Gate-Kathoden-Spannung und etwa 100 V Anoden-Kathodenspannung betrieben wird, ergibt sich eine Verlustleistung im Bauelement von 0,33 W. Für die genannte Verlustleistung sind keine besonderen Kühlmaßnahmen erforderlich.

**Tabelle:**

| Betriebsbedingungen für einen mikroelektronischen Verteilerschalter in einer Zündanlage | |
|---|---|
| Zündspannung | 15 bis 25 kV |
| Brenndauer | 2 ms |
| Brennspannung | 500 V |
| Zündkerzenstrom | 40 mA (Mittelwert) |
| Periode | 24 ms (5000 U/min) |
| Verhältnis ein/Periode | 1:12 |
| Spannungsabfall | 100 V (Anode, Kathode) |
| Verlustleistung | 0,33 W (je Feldemitter) |

Die vakuummikroelektronischen Hochspannungsschalter und elektrischen Zuführungen lassen sich in einem kleinen Gehäuse, dessen geschätzte Größe von 2 cm³ im wesentlichen durch die Kabelanschlüsse für den Hochspannungsbus und die Ansteuerleitung und den Zündkerzenstecker bestimmt wird, unterbringen.

Das Gehäuse mit den Hochspannungsschaltern ist in seiner Größe mit der Größe heutiger Zündkerzenstecker vergleichbar.

Durch einen Feldemitter als steuerbaren Hochspannungs-Längswiderstand 7b eröffnen sich Möglichkeiten für neuartige Zündsysteme einschließlich neuartiger Zündkerzen.

### Beispiel 2:

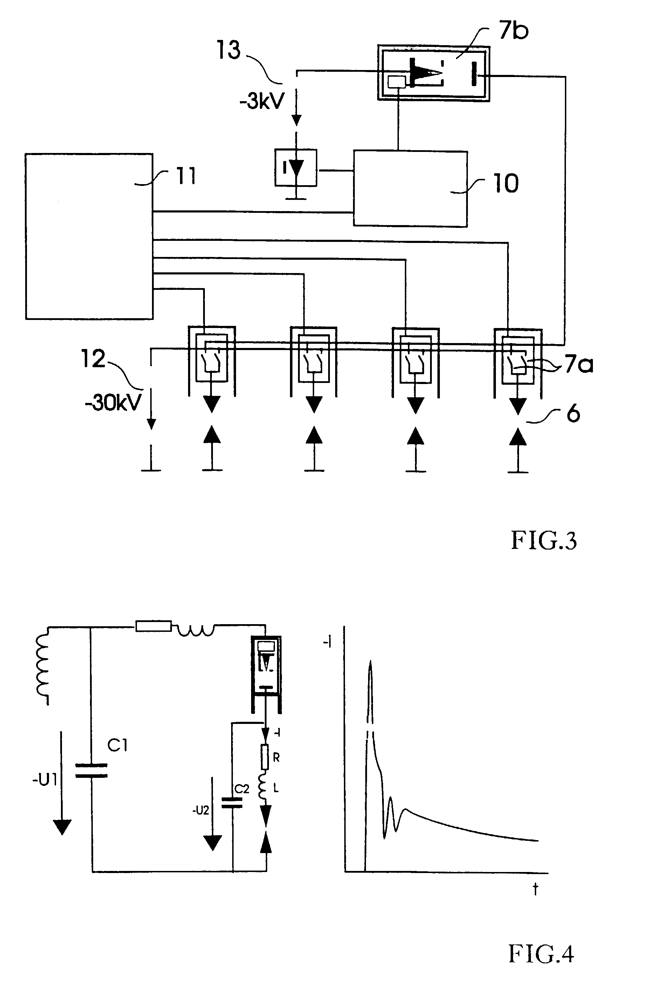

Die Fig. 3 zeigt als weiteres Ausführungsbeispiel ein Zündkonzept für geregelten Zündstrom. Mit 10 sind die Stromregelung für den Feldemitter 7b und mit 11 das Zündmanagement bezeichnet. Für den gesamten Zünd- und Brennvorgang sind zwei Spannungsquellen mit 30 kV und 3 kV vorgesehen. Die angegebenen Spannungswerte sind als Anhaltswerte zu verstehen.

Der Start des Zündvorgangs, der durch die Erzeugung elektrischer Ladungsträger zwischen den Zündkerzenelektroden gekennzeichnet ist, wird im Ausführungsbeispiel 2 durch Verbinden eines Hochspannungsbusses 12, auf dem eine Hochspannung von 30 kV liegt, mit einer Zündkerzenelektrode über Feldemitter-Schalter 7a hervorgerufen.

Nachdem der Zündvorgang gestartet ist, wird die 30 kV-Spannungsquelle durch Öffnen des Feldemitterschalters von der Zündkerze nach kurzer Zeit abgetrennt und eine Quelle mit regelbarem Strom und einem Spannungsbereich von 300 V bis 3 kV über einen weiteren Feldemitter ohne Unterbrechung des Zündvorganges an die Zündkerzenelektrode geschaltet und damit die Entladung fortgesetzt. Der Nachentladevorgang benötigt einige ms. Die geregelte Stromquelle besteht aus der 3 kV-Spannungsquelle und der Regelschaltung 10 mit dem Feldemitter 7b. Die Funktion der Stromregelung durch das Feldemitter-Element 7b kann auch in integrierter Form als Zusatzfunktion von Feldemitter-Element 7a erfüllt werden.

Das zuvor beschriebene Zündsystem (Ausführungsbeispiel 2) mit Stromregelung zeigt, wie durch den direkten Eingriff in den Zündkerzenstromkreis die Verbrennung im Zylinderraum gesteuert werden kann. Für den Hochspannungskreis der Zündkerzen gab es bisher keine geeigneten und zuverlässigen Hochspannungsbauelemente.

Beim Zündsystem mit mechanischem Verteiler werden unmittelbar nach dem Zünden die Zuleitungs- und Zündkerzen kapazitäten mit Spitzenströmen entladen, die einen hohen Anteil am Verschleiß der Zündkerze bewirken.

Durch den mikroelektronischen Verteilerschalter 7a in Fig. 2 bzw. Fig. 3 wird der Entladestrom der Zuleitungs- und Aufbaukapazität C1 vorteilhaft auf einen durch die Gate-Spannung eingestellten Wert I_{GR} begrenzt. Prinzipbild und Stromverlauf sind in Fig. 4 dargestellt. Die Strombegrenzung ermöglicht eine deutliche Verlängerung der Lebensdauer der Zündkerzen.

Die Fig. 4 zeigt ein vereinfachtes Ersatzschaltbild des Zündanlagensekundärkreises der Fig. 2 mit mikroelektronischem Verteilerschalter und den prinzipiellen zeitlichen Verlauf des Zündkerzenstromes kurz nach dem Zünden. Die Hochspannung an der Spule Ist mit U1, die Spannung an der Zündkerze mit U2, die Zuleitungskapazität mit C1, die Zündkerzen kapazität mit C2 und der Zündkerzenstrom ist mit i bezeichnet.

Ein Systemvorteil eines Zündsystems mit Hochspannungs-Schaltern bzw. steuerbaren Längswiderständen auf der Hochspannungsseite besteht in der Möglichkeit, die Brenndauer der Zündkerze bzw. den Strom aktiv zu steuern. Da die Zündkerzenlebensdauer (Erosion) annähernd linear von der über die Zündkerzen fließenden Ladungsmenge abhängt, lassen sich durch eine an den Betriebszustand des Motors angepaßte Brenndauer bzw. Stromregelung die Zündkerzenwartungsintervalle verlängern. Zusammen mit einer Langlebensdauerzündkerze und einer integrierten elektronischen Zündkerzenzustandsüberwachung könnten Zündkerzenwartungsinteralle entfallen. Die Zündkerzenlebensdauer kann damit die Motorlebensdauer erreichen.

Darüber hinaus bietet die gezielte Steuerung von Zündzeitpunkt, Entladedauer sowie Entladestromhöhe neue Möglichkeiten beim modernen Motormanagement für eine erheblich weitergehende Optimierung des Verbrennungsvorgangs, wie z. B. der Abgas- und Verbrauchsreduzierung.

## Patentansprüche

1. Zündanlage mit mindestens einer Hochspannungsquelle zur Erzeugung und Aufrechterhaltung des Zündfunkens In einer Zündkerze und mindestens einem Steuergerät zur Erzeugung des Zündtaktes und zur Steuerung des Zündvorgangs,
dadurch gekennzeichnet,
daß die Hochspannung über mindestens einen Feldemitter (7) an die Zündkerze (6) gelegt ist.

2. Zündanlage nach Anspruch 1,
dadurch gekennzeichnet,
daß das Feldemitter (7) aus einer Parallelschaltung von vakuummikroelektronischen Feldemittern (1) mit mindestens einer Kathode (2), einem Gate (3) und einer Anode (4) besteht.

3. Zündanlage nach Anspruch 1 oder 2,
dadurch gekennzeichnet,
daß ein Zündspannungsbus (8) vorgesehen ist, welcher die Kathode (2) jedes Feldemitters (7) mit Hochspannung versorgt, daß eine Steuerelektronik (9) vorgesehen ist, welche Zeitpunkt und Dauer des Zündvorgangs einstellt und daß die Anode (4) oder Kathode (2) des Feldemitters (7) mit der Zündkerze elektrisch leitend verbunden ist.

4. Zündanlage nach einem der Ansprüche 1 bis 3,
dadurch gekennzeichnet,
daß die Zündspannung 15 - 30 kV beträgt.

5. Zündanlage nach einem der Ansprüche 1 bis 4,
dadurch gekennzeichnet,
daß der Feldemitter (7) direkt auf die Zündkerze (6) aufgesteckt ist.

6. Zündanlage nach einem der Ansprüche 1 bis 5,
dadurch gekennzeichnet,
daß Feldemitter (7) und Zündkerze (6) in integrierter Bauweise als kompaktes Bauelement ausgeführt sind.

7. Zündanlage nach einem der Ansprüche 1 bis 6,
dadurch gekennzeichnet,
daß durch eine Stromregelung (10) der Strom durch die Zündkerze (6) auf einen Wert im Bereich von 20 bis 200 mA eingestellt wird.

8. Zündanlage nach einem der Ansprüche 1 bis 7,
dadurch gekennzeichnet,
daß eine zusätzliche Brennspannungsquelle im Bereich von 300 V bis 3 kV mit Steuerung über Feldemitter eingesetzt wird bei einer Brenndauer von 0,5 - 5 ms.

9. Zündanlage nach einem der Ansprüche 1 bis 8,
dadurch gekennzeichnet,
daß ein Feldemitter (7) etwa 10⁴ bis 10⁵ vakuummikroelektronische Einzelelemente (1) besitzt.

10. Zündanlage nach einem der Ansprüche 1 bis 9,
dadurch gekennzeichnet,
daß der Feldemitter (7) als Stellglied in einem Stromregelkreis wirkt.

## Claims

1. Ignition system with at least one high-voltage source for generation and maintenance of the ignition spark in a spark plug and at least one control apparatus for generation of the ignition timing and for control of the ignition process, characterised thereby that the high voltage is applied to the spark plug (6) by way of at least one field emitter (7).

2. Ignition system according to claim 1, characterised thereby that the field emitter (7) consists of a parallel connection of vacuum micro-electronic field emitters (1) with at least one cathode (2), a gate (3) and an anode (4).

3. Ignition system according to claim 1 or 2, characterised thereby that an ignition voltage bus (8) is provided, which supplies the cathode (2) of each field emitter (7) with high voltage, that an electronic control system (8) is provided, which sets the instant and duration of the ignition process, and that the anode (4) or cathode (2) of the field emitter (7) is electrically conductively connected with the spark plug.

4. Ignition system according to one of claims 1 to 3, characterised thereby that the ignition voltage amounts to 15 to 30 kilovolts.

5. Ignition system according to one of claims 1 to 4, characterised thereby that the field emitter (7) is plugged directly onto the spark plug (6).

6. Ignition system according to one of claims 1 to 5, characterised thereby that the field emitter (7) and spark plug (6) are constructed in integrated mode of construction as a contact constructional element.

7. Ignition system according to one of claims 1 to 6, characterised thereby that the current through the spark plug (6) is set to a value in the region of 20 to 200 mA by a current regulation (10).

8. Ignition system according to one of claims 1 to 7, characterised thereby that an additional combustion voltage source in the region of 300 V to 3 kV with control by way of field emitters is used for a combustion duration of 0.5 to 5 ms.

9. Ignition system according to one of claims 1 to 8, characterised thereby that a field emitter (7) possesses approximately 10⁴ to 10⁵ vacuum micro-electronic individual elements (1).

10. Ignition system according to one of claims 1 to 9, characterised thereby that the field emitter (7) acts as a setting element in a current regulating circuit.

## Revendications

1. Système d'allumage comportant au moins une source de haute tension pour produire et maintenir l'étincelle d'allumage dans une bougie d'allumage et au moins un appareil de commande pour produire le rythme de l'allumage et pour commander le processus d'allumage,
caractérisé
par le fait que la haute tension arrive à la bougie d'allumage (6) par l'intermédiaire d'au moins un émetteur à effet de champ (7).

2. Système d'allumage selon la revendication 1,
caractérisé
par le fait que l'émetteur à effet de champ (7) est constitué d'un circuit parallèle d'émetteurs à effet de champ (1) de la micro-électronique sous vide, comprenant au moins une cathode (2), une grille (3) et une anode (4).

3. Système d'allumage selon la revendication 1 ou 2,
caractérisé
par le fait qu'est prévu un bus (8) de la tension d'allumage qui alimente en haute tension la cathode (2) de chaque émetteur à effet de champ (7), qu'est prévu un circuit électronique de commande (9) qui détermine l'instant et la durée du processus d'allumage et que l'anode (4) ou la cathode (2) de l'émetteur à effet de champ (7) est reliée, avec conduction électrique, à la bougie d'allumage.

4. Système d'allumage selon l'une des revendications 1 à 3,
caractérisé
par le fait que la tension d'allumage vaut 15-30 kV.

5. Système d'allumage selon l'une des revendications 1 à 4,
caractérisé
par le fait que l'émettcur à effet de champ (7) est directement enfiché sur la bougie d'allumage (6).

6. Système d'allumage selon l'une des revendications 1 à 5,
caractérisé
par le fait que l'émetteur à effet de champ (7) et la bougie d'allumage (6) sont réalisés, en mode intégré, sous forme d'un composant compact.

7. Système d'allumage selon l'une des revendications 1 à 6,
caractérisé
par le fait que grâce à une régulation du courant (10), le courant qui passe à travers la bougie d'allumage (6) est réglé à unc valeur valant de 20 à 200 mA.

8. Système d'allumage selon l'une des revendications 1 à 7,
caractérisé
par le fait que, pour une durée de (),5-5 ms, on emploie une source supplémentaire de tension d'arc sur la plage de 300 V à 3 kV avec commande par l'intermédiaire d'émetteurs à effet de champ.

9. Système d'allumage selon l'une des revendications 1 à 8,
caractérisé
par le fait qu'un émetteur à effet de champ (7) possède environ 10⁴ à 10⁵ éléments individuels (1) de la micro-électronique sous vide.

10. Système d'allumage selon l'une des revendications 1 à 9,
caractérisé
par le fait que l'émetteur à effet de champ (7) intervient comme élément réglant dans un circuit de régulation du courant.
